# EUROPEAN PATENT APPLICATION

(11) **EP 4 709 098 A2**
(43) Date of publication of application: **11.03.2026**
(21) Application number: 26152371.6
(22) Date of filing: 16.01.2026
(51) Int. Cl.: H10F 19/80

(54) **PHOTOVOLTAIC MODULE**

(30) Priority: 10.12.2025 CN 202511866996
(71) Applicant: Jinko Solar (Haining) Co., Ltd., Haining City, Zhejiang 314415 (CN)
(72) Inventor: TAO, Wusong, Haining City, Zhejiang 314415 (CN); WANG, Rong, Haining City, Zhejiang 314415 (CN); XIE, Yunfei, Haining City, Zhejiang 314415 (CN); ZHANG, Dongqi, Haining City, Zhejiang 314415 (CN); WANG, Chunzhi, Haining City, Zhejiang 314415 (CN)
(74) Representative: Schwarz & Partner Patentanwälte GmbH

(57) **Abstract**

A photovoltaic module (100) includes: a solar cell string (10); a first adhesive film (20) and a second adhesive film (30) respectively located on two sides of the solar cell string; and a cover glass (50) provided on a side surface of the second adhesive film away from the solar cell string, the cover glass including a first surface (510) and a second surface (520) oppositely arranged, the cover glass being provided with a through hole (530) including a first transition region (531), a central circular hole region (532), and a second transition region (533) that are sequentially in communication, a diameter (D1) of the first transition region (531) increases from the central circular hole region (532) to the first surface (510), and a diameter (D3) of the second transition region (533) increases from the central circular hole region (532) to the second surface (520).

## Description

### TECHNICAL FIELD

The present invention relates to the field of photovoltaic technologies, and in particular, to a photovoltaic module.

### BACKGROUND

Currently, a mounting hole in a backplate glass of a conventional photovoltaic module is mostly designed as a circular hole, which leads to severe stress concentration at a hole edge. A stress peak at the hole edge is 3 to 5 times of the average stress, thereby easily resulting in glass breakage.

### SUMMARY

Accordingly, it is necessary to provide a photovoltaic module to address the problem of stress concentration.

A photovoltaic module is provided, including: a solar cell string; a first adhesive film and a second adhesive film located on two sides of the solar cell string, respectively; and a cover glass provided on a side surface of the second adhesive film away from the solar cell string, the cover glass including a first surface and a second surface, the cover glass being provided with a through hole, the through hole including a first transition region, a central circular hole region, and a second transition region that are sequentially in communication, an diameter of the first transition region increases from the central circular hole region to the first surface, and an diameter of the second transition region increases from the central circular hole region to the second surface.

In some embodiments, in a radial direction of the central circular hole region, a width of the first transition region ranges from 1.75 mm to 3 mm.

In some embodiments, in a radial direction of the central circular hole region, a width of the second transition region ranges from 1.25 mm to 2 mm.

In some embodiments, the first transition region is a truncated cone region with an inclination angle ranging from 15° to 25°.

In some embodiments, the second transition region is a truncated cone region with an inclination angle ranging from 15° to 25°.

In some embodiments, a difference between an inclination angle of the first transition region and an inclination angle of the second transition region is within 3°.

In some embodiments, in the thickness direction, a length of the second transition region is less than that of the first transition region.

In some embodiments, a thickness of the cover glass ranges from 2.5 mm to 3.2 mm.

In some embodiments, the cover glass includes a first glass, an adhesive layer, and a second glass that are sequentially laminated, and the central circular hole region extends through the adhesive layer and extends into the first glass and the second glass.

In some embodiments, thicknesses of the first glass and the second glass are equal, and the first transition region and the second transition region are symmetrically arranged about a center of the cover glass in the thickness direction.

In some embodiments, thicknesses of the first glass and the second glass both range from 2.5 mm to 3.2 mm.

In some embodiments, a diameter of an opening of the first transition region on the first surface ranges from 10 to 12 mm, and a length of the first transition region in the thickness direction ranges from 0.8 to 1.2 mm.

In some embodiments, the central circular hole region has a diameter ranging from 6.5 mm to 7 mm with a tolerance of ±0.05 mm, and a length of the central circular hole region in the thickness direction ranging from 1.0 mm to 1.5 mm.

In some embodiments, a diameter of an opening of the second transition region on the second surface ranges from 9 mm to 11 mm, and a length of the second transition region in the thickness direction ranges from 0.5 mm to 1 mm.

In some embodiments, a chemically tempered layer is provided on an inner wall surface of the through hole, and the chemically tempered layer extends into the cover glass.

In the above photovoltaic module, by dividing the through hole into three sections in the thickness direction of the cover glass and by arranging the first transition region between the central circular hole region and the first surface and arranging the second transition region between the central circular hole region and the second surface, a gradient transition zone with a specific width in the radial direction of the central circular hole region is formed between the central circular hole region and the first surface, and a gradient transition zone with a specific width in the radial direction of the central circular hole region is also formed between the central circular hole region and the second surface, thereby enabling the stress to "diffuse outwards in three dimensions". Both the first transition region and the second transition region form a stress buffer zone. This design in the present invention forms a "double-funnel"-shaped three-dimensional structure in the thickness direction, which is no longer a single inclined plane but a segmented depth-varying three-dimensional profile. Stress testing indicates that employing the solution of the present invention can reduce a stress concentration coefficient and increase a static load, thereby effectively preventing fracture of the cover glass.

### BRIEF DESCRIPTION OF THE DRAWINGS

FIG. 1 is a schematic view of a photovoltaic module according to some embodiments of the present invention;
FIG. 2 is a schematic view of a cover glass in the photovoltaic module according to an embodiment of the present invention;
FIG. 3 is a schematic view of the cover glass in the photovoltaic module according to another embodiment of the present invention;
FIG. 4 is a schematic view of the cover glass in the photovoltaic module according to yet another embodiment of the present invention; and
FIG. 5 is a schematic view showing a chemically tempered layer provided on an inner wall surface of a mounting hole.

### Reference signs:

100: photovoltaic module; 10: solar cell string; 20: first adhesive film; 30: second adhesive film; 40: front encapsulation structure; 50: cover glass; 510: first surface; 520: second surface; 530: through hole; 531: first transition region; 532: central circular hole region; 533: second transition region; 501: first glass; 502: second glass; 503: adhesive layer; 540: chemically tempered layer.

### DETAILED DESCRIPTION

In order to make the above objectives, features and advantages of the present invention more obvious and understandable, specific implementations of the present invention are described in detail below with reference to the accompanying drawings. In the following description, many specific details are set forth in order to fully understand the present invention. However, the present invention can be implemented in many other manners different from those described herein, and those skilled in the art can make similar improvements without departing from the connotation of the present invention. Therefore, the present invention is not limited by the specific implementation disclosed below.

In the description of the present invention, it should be understood that the orientation or position relationship indicated by the terms "central", "longitudinal", "transverse", "length", "width", "thickness", "upper", "lower", "front", "back", "left", "right", "vertical", "horizontal", "top", "bottom", "inner", "outer", "clockwise", "counterclockwise", "axial", "radial", "circumferential", and the like are based on the orientation or position relationships shown in the accompanying drawings and are intended to facilitate the description of the present invention and simplify the description only, rather than indicating or implying that the apparatus or element referred to must have a particular orientation or be constructed and operated in a particular orientation, and therefore cannot be interpreted as limiting the present invention.

In addition, the terms "first" and "second" are used for descriptive purposes only, which cannot be construed as indicating or implying a relative importance, or implicitly specifying the number of the indicated technical features. Therefore, the features defined with "first" and "second" may explicitly or implicitly include at least one feature. In the description of the present invention, "a plurality of" means at least two, such as two or three, unless otherwise defined explicitly and specifically.

In the present invention, unless otherwise specified and defined explicitly, the terms "mount", "connect", "join", and "fix" should be understood in a broad sense, which may be, for example, a fixed connection, a detachable connection, or an integral connection; a mechanical connection or an electrical connection; or a direct connection, an indirect connection via an intermediate medium, an internal connection between two elements, or interaction between two elements, unless otherwise explicitly defined. Those of ordinary skill in the art can understand specific meanings of these terms in the present invention according to specific situations.

In the present invention, unless otherwise explicitly specified and defined, the expression a first feature being "on" or "under" a second feature may be the case that the first feature is in direct contact with the second feature, or the first feature is in indirect contact with the second feature via an intermediate medium. Furthermore, the expression the first feature being "over", "above", or "on top of" the second feature may be the case that the first feature is directly above or obliquely above the second feature, or only means that the level of the first feature is higher than that of the second feature. The expression the first feature being "below", "underneath", or "under" the second feature may be the case that the first feature is directly underneath or obliquely underneath the second feature, or only means that the level of the first feature is lower than that of the second feature.

It should be noted that when one element is referred to as being "fixed to" or "arranged on" another element, it may be directly disposed on the other element or an intermediate element may exist. When one element is considered to be "connected to" another element, it may be directly connected to the other element or an intermediate element may coexist. The terms "vertical", "horizontal", "left", "right" and similar expressions used herein are for illustrative purposes only and do not represent an only implementation.

As described in the background, the mounting hole in the conventional photovoltaic module has a problem of stress concentration, and conventional solutions cannot effectively solve the problem.

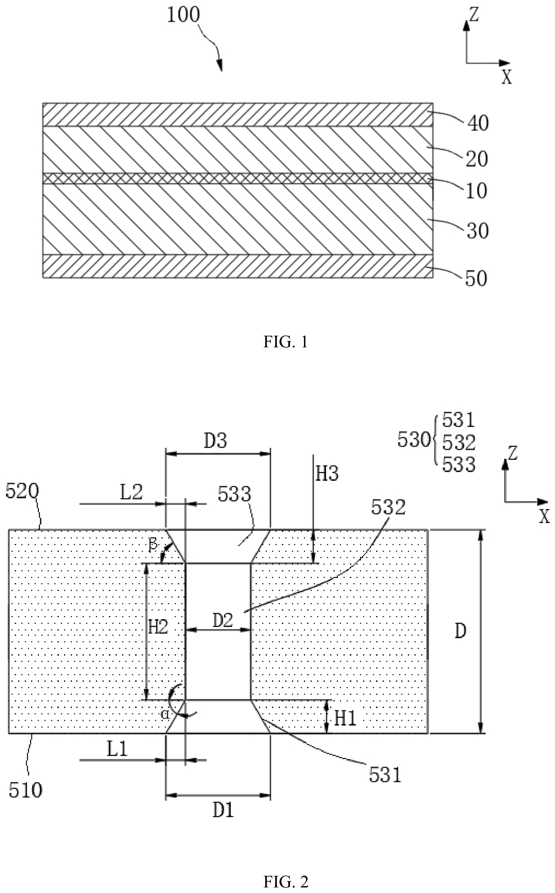

With respect to the above requirement, referring to FIG. 1 and FIG. 2, the present invention provides a photovoltaic module 100, including a solar cell string 10, a first adhesive film 20, a second adhesive film 30, a front encapsulation structure 40, and a cover glass 50.

The first adhesive film 20 and the second adhesive film 30 are located on two sides of the solar cell string 10, respectively. The front encapsulation structure 40 is provided on a side surface of the first adhesive film 20 away from the solar cell string 10. The cover glass 50 is provided on a side surface of the second adhesive film 30 away from the solar cell string 10. The cover glass 50 includes a first surface 510 and a second surface 520 that are oppositely arranged in a thickness direction thereof. The cover glass 50 is provided with a through hole 530. The through hole 530 includes a first transition region 531, a central circular hole region 532, and a second transition region 533 that are sequentially in communication. A diameter D1 of the first transition region 531 increases from the central circular hole region 532 to the first surface 510, and a diameter D3 of the second transition region 533 increases from the central circular hole region 532 to the second surface 520.

The solar cell string 10 includes at least one photovoltaic cell. In this embodiment, a structure of the photovoltaic cell is not limited. Types of the photovoltaic cell include, but are not limited to, a passivated emitter rear cell (PERC), a tunnel oxide passivated contact (TOPCon) solar cell, a heterojunction with intrinsic thin-film (HJT) solar cell, an interdigitated back contact (IBC) solar cell, a perovskite solar cell, and the like.

For example, the first adhesive film 20 and the second adhesive film 30 may be made of one of the following materials: an ethylene-vinyl acetate copolymer (EVA), a polyolefin elastomer (POE), polyvinyl butyral (PVB), an EVA-POE-EVA (EPE) co-extruded adhesive film, an EVA-POE (EP) co-extruded adhesive film, and the like.

For example, the front encapsulation structure 40 may be made of one of rigid materials such as tempered glass, polyethylene terephthalate (PET), and polycarbonate (PC) or one of flexible materials such as polyvinyl fluoride (PVF), ethylene-tetra-fluoro-ethylene (ETFE), and polyvinylidene fluoride (PVDF). The above materials have relatively high light transmittance, which can enhance photoelectric conversion efficiency of the photovoltaic module 100 and ensure power of the photovoltaic module 100. When the photovoltaic module 100 is in operation, the front encapsulation structure 40 faces the sun.

In the present invention, the cover glass 50 is configured to form a back encapsulation structure of the photovoltaic module 100. When the photovoltaic module 100 is in operation, the cover glass 50 is away from the sun. The first surface 510 is located on an outer side of the photovoltaic module 100 and is away from the solar cell string 10. A thickness direction of the cover glass 50 is also a thickness direction of the photovoltaic module 100, and is also a stacking direction of various components.

The through hole 530 extends through the cover glass 50 in the thickness direction and is divided into three parts in the thickness direction. With respect to a placement direction of the cover glass 50 as illustrated in FIG. 2, an upper end of the first transition region 531 is in communication with a lower edge of the through hole 530, and a lower end of the first transition region 531 extends through the first surface 510 of the cover glass 50. A lower end of the second transition region 533 is in communication with an upper edge of the central circular hole region 532, and an upper end of the second transition region 533 extends through the second surface 520 of the cover glass 50.

The central circular hole region 532 is a circular hole with a constant diameter. In the thickness direction, i.e., in a direction from the second surface 520 to the first surface 510, a diameter of the first transition region 531 gradually increases. A diameter at a junction between the first transition region 531 and the central circular hole region 532 is less than that at the middle of the first transition region 531, and the diameter at the middle of the first transition region 531 is less than that at the opening of the first transition region 531 on the first surface 510. In the thickness direction, i.e., in a direction from the first surface 510 to the second surface 520, a diameter of the second transition region 533 gradually increases. A diameter at a junction between the second transition region 533 and the central circular hole region 532 is less than that at the middle of the second transition region 533, and the diameter at the middle of the second transition region 533 is less than that at the opening of the second transition region 533 on the second surface 520.

In the conventional art, an inclined surface is formed around edges of the mounting hole. However, this manner has significant limitations: this manner treats a single plane, typically involving only a simple chamfer at 45° or another angle on a glass surface (or one side), and only stress dispersion at a hole edge within a single plane is considered.

In the present invention, by dividing the through hole 530 into three sections in the thickness direction of the cover glass 50 and by arranging the first transition region 531 between the central circular hole region 532 and the first surface 510 and arranging the second transition region 533 between the central circular hole region 532 and the second surface 520, a gradient transition zone with a specific width in the radial direction of the central circular hole region 532 is formed between the central circular hole region 532 and the first surface 510, and a gradient transition zone with a specific width in the radial direction of the central circular hole region 532 is also formed between the central circular hole region 532 and the second surface 520, thereby enabling the stress to "diffuse outwards in three dimensions". Both the first transition region 531 and the second transition region 533 form a stress buffer zone. This design in the present invention forms a "double-funnel"-shaped three-dimensional structure in the thickness direction, which is no longer a single inclined plane but a segmented depth-varying three-dimensional profile. Stress testing indicates that employing the solution of the present invention can reduce a stress concentration coefficient and increase a static load, thereby effectively preventing fracture of the cover glass 50.

In addition, when the through hole 530 is connected to a mounting bolt, the mounting bolt is inserted into the through hole 530 from one side of the first surface 510. Two transition regions 531 and 533 are provided on both side of the central circular hole region 532, thus forming a "dual-funnel" stress transfer channel. An external load can be distributed through the first transition region 531 to the central circular hole region 532, then undergoes secondary distribution via the second transition region 533, thereby achieving two-stage stress gradient transition.

Optionally, in the radial direction of the central circular hole region 532, a width of the first transition region 531 ranges from 1.75 mm to 3 mm. For example, the width of the first transition region 531 is 1.75 mm, 2 mm, 2.25 mm, 2.4 mm, or 3 mm. Optionally, in the radial direction of the central circular hole region 532, a width of the second transition region 533 ranges from 1.25 mm to 2 mm. For example, the width of the second transition region 533 is 1.25 mm, 1.35 mm, 1.5 mm, 1.9 mm, or 2 mm.

The radial direction of the central circular hole region 532 is specifically a direction X in FIG. 1 and FIG. 2. The width of the first transition region 531 refers to a width L1 of an inner wall of the first transition region 531 in the radial direction of the central circular hole region 532. The inner wall of the first transition region 531 is ring-shaped. The width of the first transition region 531 refers to a radial width of the inner wall of the first transition region 531 in a cross-section of the central circular hole region 532.

Similarly, the width of the second transition region 533 refers to a width L2 of an inner wall of the second transition region 533 in the radial direction of the central circular hole region 532. The inner wall of the second transition region 533 is ring-shaped. The width of the second transition region 533 refers to a radial width of the inner wall of the second transition region 533 in a cross-section of the central circular hole region 532.

Based on the Griffith theory of fracture mechanics, critical stress for crack propagation is inversely proportional to a stress gradient. Finite element analysis proves that a 3 mm transition region reduces the stress gradient from 45 MPa/mm in the conventional solution to 18 MPa/mm, which is less than a glass fatigue crack propagation threshold (25 MPa/mm).

Optionally, the first transition region 531 is a truncated cone region with an inclination angle α ranging from 15° to 25°. Optionally, the second transition region 533 is a truncated cone region with an inclination angle β ranging from 15° to 25°. Referring to FIG. 1, the inclination angle of the truncated cone region is an angle between a generatrix of the truncated cone and a top surface or bottom surface.

According to stress diffusion theory, a natural diffusion angle of a point load ranges from 30° to 45° within a brittle material. The inclination angle is set to less than 60% of the diffusion angle (i.e., <27°) to fully utilize a diffusion effect. In addition, in the photovoltaic module 100, the back encapsulation structure has a limited thickness. For example, the thickness D of the cover glass 50 ranges from 2.5 mm to 3.2 mm. Therefore, in the present invention, the inclination angle is configured within a range of 15° to 25°, which, on the one hand, can prevent a situation where an excessively small angle would cause the length of the transition region to exceed a thickness of the glass, leading to impossible implementation, and on the other hand, can also prevent a situation where an excessively large and steep angle would result in an insufficient reduction of stress, failing to achieve a purpose of stress optimization. In the present invention, the inclination angles of the first transition region 531 and the second transition region 533 are configured within the range of 15° to 25°, which can achieve an optimal balance between manufacturing efficiency and stress optimization. For example, the inclination angles of the first transition region 531 and the second transition region 533 may be 15°, 18°, 20°, 23°, and 25°, respectively.

In some embodiments, a difference between the inclination angle of the first transition region 531 and the inclination angle of the second transition region 533 is within 3°. For example, the difference between the inclination angles is 1°, 1.5°, 2°, or 3°.

With reference to the above, the arrangement of the first transition region 531 and the second transition region 533 is intended to achieve seamless three-dimensional smooth transition. An external load is distributed through the first transition region 531 to the central circular hole region 532, and then undergoes secondary distribution via the second transition region 533, thus achieving a two-stage stress gradient transition. In the present invention, the difference between the inclination angle of the first transition region 531 and the inclination angle of the second transition region 533 is within 3°, which can ensure continuous dispersion of stress flow lines at a junction of the truncated cones and prevent abrupt geometric changes in a stress transmission path.

Specifically, if the difference between the inclination angle of the first transition region 531 and the inclination angle of the second transition region 533 is excessively large, taking the first transition region 531 as an example, a step-like abrupt change may be formed at a junction between the first transition region 531 and the central circular hole region 532, which prevents smooth transition of the stress flow lines, resulting in secondary stress concentration at the interface. If the difference is excessively small, a gradient diffusion effect cannot be fully utilized, which also leads to excessive local stress peaks and formation of new stress concentration points/new weak points. If the difference between the inclination angle of the first transition region 531 and the inclination angle of the second transition region 533 is within 3°, the above problems can be effectively prevented.

The cover glass 50 may be, for example, ultra-clear tempered glass or low-iron float glass. In addition, referring to FIG. 2, in this embodiment, the cover glass 50 is a single-layer glass, and the thickness thereof may range from 2.5 mm to 3.2 mm, for example, 2.5 mm, 2.6 mm, 2.7 mm, 2.8 mm, 2.9 mm, 3.0 mm, 3.1 mm, or 3.2 mm. In the thickness direction, a length of the first transition region 531 is equal to that of the second transition region 533. Optionally, the first transition region 531 and the second transition region 533 are symmetrically arranged about a center of the cover glass 50 in the thickness direction.

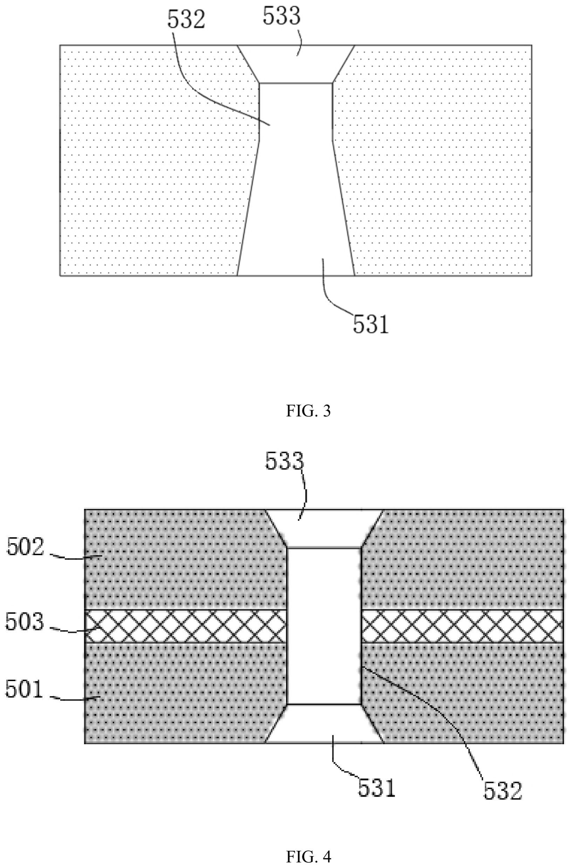

Different from the embodiment shown in FIG. 2, referring to FIG. 3, in some embodiments, in the thickness direction, a length H3 of the second transition region 533 is less than a length H1 of the first transition region 531.

In the photovoltaic module 100, the first transition region 531 faces an external environment of the photovoltaic module 100, while the second transition region 533 faces the interior of the photovoltaic module 100. The first transition region 531 directly bears contact pressure from the mounting bolt. Research has found that 85% of cracks originate from an outer pressure-bearing surface.

Therefore, in this embodiment, since the lengths of the first transition region 531 and the second transition region 533 are different, and the length of the first transition region 531 is greater than that of the second transition region 533, the fracture resistance of the first transition region 531 can be enhanced. Moreover, in the case of an effective glass thickness, the differential length design of the first transition region 531 and the second transition region 533 can enhance the fracture resistance of the first transition region 531 while ensuring the length of the central circular hole region 532, which may not reduce overall stiffness of the cover glass 50.

In some other embodiments, the cover glass 50 may alternatively be a double-layer glass. Referring to FIG. 4, the cover glass 50 includes a first glass 501, an adhesive layer 503, and a second glass 502 that are laminated sequentially, and the central circular hole region 532 extends through the adhesive layer 503 and extends into the first glass 501 and the second glass 502.

The first glass 501 and the second glass 502 are connected via the adhesive layer 503. The adhesive layer 503 may be made of one of the following materials: an EVA, a POE, PVB, an EPE co-extruded adhesive film, an EP co-extruded adhesive film, and the like.

In this embodiment, the through hole 530 still extends through the entire cover plate 50. The first transition region 531 is formed within the first glass 501. The second transition region 533 is formed within the second glass 502. The central circular hole region 532 extends through the first glass 501, the adhesive layer 503, and the second glass 502.

In the embodiment shown in FIG. 4, compared with FIG. 2 and FIG. 3, although the composition of the cover glass 50 may vary, the configuration of other structures, such as the length in the thickness direction, the width in the radial direction, and the inclination angles of the first transition region 531 and the second transition region 533 may be entirely identical.

Optionally, thicknesses of the first glass 501 and the second glass 502 are equal, and the first transition region 531 and the second transition region 533 are symmetrically arranged about a center of the cover glass 50 in the thickness direction. The thicknesses of the first glass 501 and the second glass 502 both range from 2.5 mm to 3.2 mm, for example, 2.5 mm, 2.6 mm, 2.7 mm, 2.8 mm, 2.9 mm, 3.0 mm, 3.1 mm, or 3.2 mm.

The symmetrical arrangement of the first transition region 531 and the second transition region 533 enables the stress to be distributed symmetrically in the two glasses, which greatly reduces shear stress at the adhesive layer 503, eliminates abrupt interfacial stress changes, and effectively prevents delamination.

In addition, the symmetrical arrangement of the first transition region 531 and the second transition region 533 further enhances adaptability to thermal cycling. Specifically, the first transition region 531 and the second transition region 533 provide a bidirectional strain release space, reduce thermal stress, and effectively accommodate differences between thermal expansion coefficients of the first glass 501, the second glass 502, and the adhesive film. The first transition region 531 and the second transition region 533 form a symmetrical stress field, so that the load is uniformly transferred through two gradient transitions, thereby improving overall bending strength.

A thickness of the adhesive layer 503 ranges from 1.0 to 1.5 mm. Optionally, the thickness of the adhesive layer 503 is 1 mm, 1.2 mm, 1.3 mm, 1.4 mm, or 1.5 mm.

In addition, it should also be noted that when the cover glass 50 is a double-layer glass, the first transition region 531 and the second transition region 533 may adopt an asymmetrical designed.

In some embodiments, the first transition region 531 has an opening on the first surface 510 with a diameter D1 ranging from 10 mm to 12 mm, and a length ranging from 0.8 mm to 1.2 mm in the thickness direction. Optionally, a diameter of the opening of the first transition region 531 is 10 mm, 10.5 mm, 11 mm, or 12 mm. The length of the first transition region 531 is 0.8 mm, 0.9 mm, 1.0 mm, 1.1 mm, or 1.2 mm.

In some embodiments, the central circular hole region 532 has a diameter D2 ranging from 6.5 mm to 7 mm with a tolerance of ±0.05 mm, and a length H2 in the thickness direction ranging from 1.0 mm to 1.5 mm. Optionally, the diameter D2 of the central circular hole region 532 is 6.5 mm, 6.6 mm, 6.7 mm, 6.8 mm, 6.9 mm, or 7 mm. The length of the central circular hole region 532 is, for example, 1.0 mm, 1.1 mm, 1.2 mm, 1.3 mm, or 1.4 mm.

The central circular hole region 532 can be used for positioning the mounting bolt, and the positioning accuracy of the central circular hole region 532 directly affects stress distribution. In this embodiment, the tolerance of ±0.05 mm means that the positioning accuracy is ±0.05 mm, for example, ±0.01 mm, ±0.02 mm, ±0.03 mm, ±0.04 mm, or ±0.05 mm. If the positioning accuracy is within the range, an eccentric contact between the bolt and a hole wall of the central circular hole region 532 can be prevented, which prevents uneven distribution of local contact stress, ensures achievement of surface stress distribution, and prevents degeneration of the surface stress distribution into point contact, thereby reducing a stress concentration coefficient at the hole edge, improving a stress dispersion effect of dual conical frusta, and reducing a risk of cracking.

In some embodiments, the second transition region 533 has an opening with a diameter D3 ranging from 9 mm to 11 mm on the second surface 520, and a length H3 ranging from 0.5 mm to 1 mm in the thickness direction. Preferably, D3 ranges from 9 mm to 10 mm, and H3 ranges from 0.5 mm to 0.8 mm. Optionally, the diameter D3 of the opening of the second transition region 533 is 9 mm, 9.2 mm, 9.6 mm, 9.8 mm, 10 mm, 10.5 mm, or 11 mm. The length H3 of the second transition region 533 is 0.5 mm, 0.6 mm, 0.7 mm, 0.8 mm, 0.9 mm, or 1 mm.

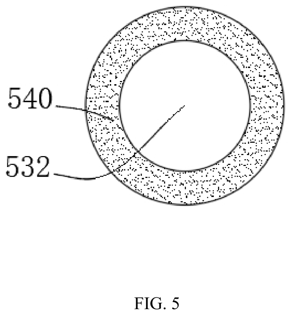

In some embodiments, a chemically tempered layer 540 is provided on an inner wall surface of the through hole 530, and the chemically tempered layer 540 extends into the cover glass 50. Referring to FIG. 5, the inner wall surface of the through hole 530 includes an inner wall surface of the first transition region 531, an inner wall surface of the central circular hole region 532, and an inner wall surface of the second transition region 533. That is, the chemically tempered layer 540 is provided on inner wall surfaces of all parts of the through hole 530. The chemically tempered layer 540 forms a compressive stress layer on an inner surface of the hole wall, which can increase a static load. A thickness of the chemically tempered layer 540 ranges from 50 µm to 70 µm. Preferably, the thickness of the chemically tempered layer 540 ranges from 55 µm to 65 µm. Optionally, the thickness of the chemically tempered layer 540 is 50 µm, 55 µm, 60 µm, 65 µm, or 70 µm.

A preparation method for the cover glass 50 is not limited. Optionally, the cover glass 50 may be formed in the following manner. A method for preparing the cover glass 50 is provided according to the present invention, including the following steps.

In S100, an intermediate of the cover glass 50 is provided, the intermediate includes, in a thickness direction, a first surface 510 and a second surface 520 that are oppositely arranged.

In S200, a through hole 530 extending through the first surface 510 and the second surface 520 is formed at a predetermined position. The through hole 530 includes a first transition region 531, a central circular hole region 532, and a second transition region 533 that are sequentially in communication. A diameter of the first transition region 531 increases from the central circular hole region 532 to the first surface 510, and a diameter of the second transition region 533 increases from the central circular hole region 532 to the second surface 520.

In S200, the forming the through hole 530 extending through the first surface 510 and the second surface 520 at the predetermined position includes the following steps.

In S210, the first transition region 531 is formed.

In S220, a circular hole region is formed at the bottom of the first transition region 531.

In S230, the second transition region 533 is formed at an end of the circular hole region.

For example, during a specific embodiment, positioning and marking are performed on the first surface 510 of the intermediate. Subsequently, layered machining is carried out using water-jet cutting/ultrasonic drilling, to respectively form the first transition region 531, the central circular hole region 532, and the second transition region 533. For example, when water-jet multilayer cutting is employed, a step-down depth may range from 0.3 mm to 0.5 mm.

The preparation method for the cover glass 50 further includes the following steps.

In S300, an inner wall of the through hole 530 is ground and polished.

In S400, an inner wall surface of the through hole 530 tempered to form a chemically tempered layer 540 that penetrates into the cover glass 50.

In S300, roughness of the inner wall surface of the through hole 530 is Ra≤0.8 µm. For example, the inner wall surface of the through hole 530 is precision-ground in a manner such as diamond grinding or laser cutting, and subsequently polished. The inner wall surface of the through hole 530 includes an inner wall surface of the first transition region 531, an inner wall surface of the central circular hole region 532, and an inner wall surface of the second transition region 533. Precision grinding and polishing ensure that the roughness of the surface is Ra≤0.8 µm and eliminate microcrack sources.

In S400, a thickness of the chemically tempered layer 540 is 60 µm. For example, the processed cover glass 50 is immersed in a salt bath of molten potassium nitrate (KNO₃), held for a set time, and then removed for cooling.

Further, an inspection step is included. Specifically, a polariscope is used for quality inspection, a stress of ≤60 MPa in the first transition region 531 and the second transition region 533 may be considered qualified.

The technical effects of the present invention will be further described below with reference to some of the above embodiments and related comparative examples.

The cover glass 50 is prepared using the design of the present invention, employing a single-layer glass and a double-layer glass respectively. In the comparative examples, the cover glass 50 is prepared using a single-layer glass with a constant-diameter circular hole design. The cover glass 50 obtained by the above method is subjected to stress testing to compare stress concentration coefficients. Simultaneously, static load tests are conducted to compare static loads.

A method for stress testing specifically includes: using a polariscope to measure stress distribution around the hole, and comparing stress concentration coefficients of a conventional circular hole design and a dual-transition-region structure. A method for static load testing includes: applying axial pressure to the mounting hole by using a universal testing machine, recording failure load values, and comparing magnitude of improvement. A plurality of samples are tested separately in the comparative examples and the embodiments of the present invention, obtaining respective ranges of stress concentration coefficients and changes in static loads.

Results are shown in Table 1 below.

**Table 1**

| | Diame ter of circula r hole in the prior | Diame ter D 1 of openin g of first | Lengt h of first transiti on region | Inclina tion angle of first transiti on | Diame ter D2 of central circula r hole | Lengt h H2 of central circula r hole | Diame ter D3 of openin g of second | Lengt h H3 of second transiti on | Taper of second transiti on region | Thick ness of adhesi ve layer | Stress conce ntratio n coeffic ient | Increa se in static load |
|---|---|---|---|---|---|---|---|---|---|---|---|---|
| Comparative example | 6.5-7 | - | - | - | 6.5-7 | 3.2 | - | - | - | - | 1.8-2.0 | 120-125% |
| Embodiment 1 | | 10 | 0.8 | 25° | 6.5 | 1.2 | 9 | 0.5 | 22° | - | 1.6-1.8 | 125-130% |
| Embodiment 2 | | 11 | 1 | 24° | 6.5 | 1.2 | 9.5 | 0.6 | 18° | - | 1.6-1.8 | 128-135% |
| Embodiment 3 | | 12 | 0.8 | 15° | 6.2 | 1.2 | 10 | 0.7 | 20° | | 1.7-1.9 | 122-128% |
| Embodiment 4 | | 12 | 1.2 | 25° | 6.2 | 1 | 10 | 0.8 | 23° | - | 1.75-1.95 | 123-127% |
| Embodiment 5 | | 10.5 | 0.9 | 24° | 6.5 | 1.3 | 9.2 | 0.6 | 24° | - | 1.65-1.85 | 126-132% |
| Embodiment 6 | | 11.8 | 1.1 | 25° | 7 | 1.1 | 10 | 0.7 | 25° | - | 1.6-1.8 | 128-135% |
| Embodiment 7 | | 10.5 | 0.9 | 24° | 6.5 | - | 10.5 | 0.9 | 24° | 0.5 | 1.65-1.85 | 125-130% |
| Embodiment 8 | | 10 | 0.85 | 22° | 6 | - | 10 | 0.85 | 22° | 0.5 | 1.55-1.75 | 130-138% |
| Embodiment 9 | | 11 | 0.95 | 25° | 7 | - | 11 | 0.95 | 25° | 0.5 | 1.8-2.0 | 120-125% |

### Note:

All dimensions in Table 1 are in mm. In Embodiments 1-5, the thicknesses of the cover glass 50 are respectively 2.5 mm, 3 mm, 3 mm, 3.2 mm, and 3.2 mm. In Embodiments 6-9, the thicknesses of the first glass 501 are respectively 3.2 mm, 2.6 mm, 2.8 mm, and 3 mm, and the thicknesses of the second glass 502 are respectively 3.2 mm, 2.6 mm, 2.8 mm, and 3 mm.

The results indicate that, by employing the design of the present invention, the stress concentration coefficient of the mounting hole of the cover glass 50 may be reduced from 30.-3.5 to 1.6-2.0. The static load may be increased to 120%-138% of a reference value (e.g., 500 N). The design concept of the present invention can effectively reduce the stress concentration coefficient of the mounting hole and increase the static load.

In addition, it is found by measure the contact compressive stress at the hole edge through finite element analysis or strain gauge testing that the contact stress in the first transition region and the second transition region in the present invention is reduced by 38-47% compared to that in the prior art. Specifically, the contact stress in the comparative examples is 150 MPa, while the contact stress in the embodiments of the present invention ranges from 80 MPa to 90 MPa. In addition, it is found by testing through three-point bending tests or dynamic impact tests that crack propagation resistance of the cover glass 50 of the present invention may be improved by 28-37%.

## Claims

1. A photovoltaic module, comprising:
a solar cell string;
a first adhesive film and a second adhesive film located on two sides of the solar cell string,
respectively; and
a cover glass provided on a side surface of the second adhesive film away from the solar cell string, the cover glass comprising a first surface and a second surface, the cover glass being provided with a through hole, the through hole comprising a first transition region, a central circular hole region, and a second transition region that are sequentially in communication,
wherein a diameter of the first transition region increases from the central circular hole region to the first surface, and a diameter of the second transition region increases from the central circular hole region to the second surface.

2. The photovoltaic module according to claim 1, wherein in a radial direction of the central circular hole region, a width of the first transition region ranges from 1.75 mm to 3 mm.

3. The photovoltaic module according to any one of preceding claims, wherein in a radial direction of the central circular hole region, a width of the second transition region ranges from 1.25 mm to 2 mm.

4. The photovoltaic module according to any one of preceding claims, wherein the first transition region is a truncated cone region with an inclination angle ranging from 15° to 25°.

5. The photovoltaic module according to any one of preceding claims, wherein the second transition region is a truncated cone region with an inclination angle ranging from 15° to 25°.

6. The photovoltaic module according to any one of preceding claims, wherein a difference between an inclination angle of the first transition region and an inclination angle of the second transition region is within 3°.

7. The photovoltaic module according to any one of preceding claims, wherein in the thickness direction, a length of the second transition region is less than a length of the first transition region.

8. The photovoltaic module according to any one of preceding claims, wherein a thickness of the cover glass ranges from 2.5 mm to 3.2 mm.

9. The photovoltaic module according to any one of preceding claims, wherein the cover glass comprises a first glass, an adhesive layer, and a second glass that are sequentially laminated, and the central circular hole region extends through the adhesive layer and extends into the first glass and the second glass.

10. The photovoltaic module according to claim 9, wherein thicknesses of the first glass and the second glass are equal, and the first transition region and the second transition region are symmetrically arranged about a center of the cover glass in the thickness direction.

11. The photovoltaic module according to claim 9, wherein thicknesses of the first glass and the second glass both range from 2.5 mm to 3.2 mm.

12. The photovoltaic module according to any one of preceding claims, wherein a diameter of an opening of the first transition region on the first surface ranges from 10 to 12 mm, and a length of the first transition region in the thickness direction ranges from 0.8 to 1.2 mm.

13. The photovoltaic module according to any one of preceding claims, wherein a diameter of the central circular hole region ranges from 6.5 mm to 7 mm with a tolerance of ±0.05 mm, and a length of the central circular hole region in the thickness direction ranges from 1.0 mm to 1.5 mm.

14. The photovoltaic module according to any one of preceding claims, wherein a diameter of an opening of the second transition region on the second surface ranges from 9 mm to 11 mm, and a length of the second transition region in the thickness direction ranges from 0.5 mm to 1 mm.

15. The photovoltaic module according to any one of preceding claims, wherein a chemically tempered layer is provided on an inner wall of the through hole, and the chemically tempered layer extends into the cover glass.
